(19) Europäisches Patentamt
European Patent Office
Office européen des brevets

(11) **EP 3 053 171 B1**

(12) **EUROPÄISCHE PATENTSCHRIFT**

(45) Veröffentlichungstag und Bekanntmachung des Hinweises auf die Patenterteilung:
**10.06.2020 Patentblatt 2020/24**

(21) Anmeldenummer: **14799703.5**

(22) Anmeldetag: **07.11.2014**

(51) Int Cl.:
***H01F 7/18*** *(2006.01)*

(86) Internationale Anmeldenummer:
**PCT/EP2014/073995**

(87) Internationale Veröffentlichungsnummer:
**WO 2015/082171 (11.06.2015 Gazette 2015/23)**

(54) **ELEKTROMAGNETISCHER AKTUATOR**

ELECTROMAGNETIC ACTUATOR

ACTIONNEUR ÉLECTROMAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.12.2013 DE 102013224662**

(43) Veröffentlichungstag der Anmeldung:
**10.08.2016 Patentblatt 2016/32**

(73) Patentinhaber: **Siemens Aktiengesellschaft
80333 München (DE)**

(72) Erfinder:
• **HAHN, Andreas
03048 Cottbus (DE)**
• **KÜHN, Wolfgang
12623 Berlin (DE)**

(56) Entgegenhaltungen:
| WO-A2-97/21237 | DE-A1- 19 535 211 |
| DE-A1-102008 040 668 | DE-A1-102011 075 935 |
| US-A1- 2004 246 649 | |

**Beschreibung**

Die Erfindung bezieht sich auf ein Verfahren zum Ansteuern eines elektromagnetischen Aktuators, der eine Erregerwicklung zum Erzeugen eines Magnetfeldes und einen beweglichen Anker umfasst, wobei bei dem Verfahren zum Bewegen des Ankers von einer vorgegebenen Ausgangsstellung in eine vorgegebene Endstellung ein magnetischer Fluss in der Erregerwicklung erzeugt wird und der magnetische Fluss durch die Erregerwicklung oder eine mit dem magnetischen Fluss durch die Erregerwicklung korrelierende Flussgröße unter Bildung eines Ist-Wertes gemessen wird.

Ein derartiges Verfahren ist aus der deutschen Offenlegungsschrift DE 195 44 207 A1 bekannt. Bei dem vorbekannten Verfahren werden zur Steuerung der Bewegung des Ankers des Aktuators während der Ankerbewegung die Bewegungsgrößen, also die Beschleunigung, die Geschwindigkeit und der jeweiligen Ort des Ankers, ermittelt, nämlich unter anderem unter Auswertung des magnetischen Flusses, der durch eine Erregerwicklung des Aktuators fließt. Unter Heranziehung der errechneten Bewegungsgrößen erfolgt eine Steuerung des Stroms durch die Erregerwicklung mit Blick auf das Einhalten eines vorgegebenen Bewegungsablaufs für den Aktuator.

Verfahren zum Regeln von magnetischen Aktuatoren finden sich in den Dokumenten WO97/21237A2, DE19535211A1, DE102008040668A1 und DE2011075935A1. Verfahren zu Bewegungsabläufen von magnetischen Aktuatoren offenbaren die Dokumente EP0376493, GB2310540 und WO9007188.

Der Erfindung liegt die Aufgabe zugrunde, ein Verfahren der eingangs beschriebenen Art zu vereinfachen.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass zum Bewegen des Ankers von der Ausgangsstellung in die Endstellung der magnetische Fluss durch die Erregerwicklung geregelt wird, und zwar derart, dass der Verlauf des Ist-Werts einer fest vorgegebenen Sollflusskurve entspricht.

Ein wesentlicher Vorteil des erfindungsgemäßen Verfahrens ist darin zu sehen, dass bei diesem auf eine Ermittlung bzw. Berechnung der Bewegungsparameter des Ankers bewusst verzichtet wird. Stattdessen erfolgt erfindungsgemäß eine Regelung des magnetischen Flusses durch die Erregerwicklung anhand einer fest vorgegebenen Sollflusskurve. Es ist somit zur Durchführung des erfindungsgemäßen Verfahrens lediglich notwendig, den Istwert des magnetischen Flusses durch die Erregerwicklung oder eine mit dem magnetischen Fluss durch die Erregerwicklung korrelierende Flussgröße zu messen und die Erregerwicklung derart anzusteuern, dass eine vorgegebene Sollflusskurve eingehalten wird. Das tatsächliche Bewegungsverhalten des Ankers spielt für die erfindungsgemäße Regelung keine Rolle, so dass das Verfahren deutlich einfacher durchführbar ist als beispielsweise das eingangs erwähnte Verfahren zum Stand der Technik.

Mit Blick auf die Durchführung der Regelung wird die Spannung an der Erregerwicklung und/oder der Strom durch die Erregerwicklung im Rahmen des Regelverfahrens derart geregelt wird, dass der Istwert der vorgegebenen Sollflusskurve entspricht.

Um eine definierte Beschleunigung des Ankers zu gewährleisten, wird es als vorteilhaft angesehen, wenn die Sollflusskurve einen Anstiegsrampenabschnitt aufweist, in dem die Sollflusskurve von Null auf einen vorgegebenen Rampenendwert ansteigt.

Um sicherzustellen, dass der Anker nach Erreichen seiner Endlage in dieser Endlage gehalten wird, wird es als vorteilhaft angesehen, wenn die Sollflusskurve einen Halteabschnitt aufweist, in dem die Sollflusskurve einen konstanten Haltewert aufweist, wobei der Haltewert derart bemessen ist, dass der magnetische Fluss durch die Erregerspule den Anker in der Endlage halten kann.

Erfindungsgemäß weist die Sollflusskurve einen Anstiegsrampenabschnitt, einen Halteabschnitt und mindestens einen dazwischen liegenden Zwischenabschnitt auf.

Um eine möglichst zügige Bewegung des Ankers in die Endlage zu erreichen, wird erfindungsgemäß die Sollflusskurve als zumindest einen Beschleunigungsabschnitt vorgesehen, in dem die Sollflusswerte größer als im Halteabschnitt sind.

Mit Blick auf einen möglichst minimalen Verschleiß des Aktuators wird es als vorteilhaft angesehen, wenn der Anker bei Erreichen der Endlage nicht allzu schnell ist; demgemäß wird erfindungsgemäß vorgesehen, dass die Sollflusskurve einen Bremsabschnitt aufweist, in dem die Sollflusswerte kleiner als im Halteabschnitt sind.

Bezüglich des Messens des Istwerts wird es als vorteilhaft angesehen, wenn der magnetische Fluss durch die Erregerwicklung oder die mit dem magnetischen Fluss durch die Erregerwicklung korrelierende Flussgröße mittels eines Hallsensors gemessen wird.

Alternativ oder zusätzlich kann vorgesehen sein, dass der magnetische Fluss durch die Erregerwicklung oder die mit dem magnetischen Fluss durch die Erregerwicklung korrelierende Flussgröße gemessen wird, indem die Spannung an der Erregerspule oder die Spannung an einer Hilfsspule, die von dem Fluss, der auch die Erregerwicklung durchsetzt, oder einem dazu proportionalen Fluss durchsetzt wird, unter Bildung eines Spulenspannungsmesswertes gemessen wird und der Istwert zumindest auch durch Integration des Spulenspannungsmesswertes ermittelt wird.

Die Erfindung bezieht sich darüber hinaus auf einen Aktuator mit einer Erregerwicklung zum Erzeugen eines Magnetfeldes, einem beweglichen Anker, einem Sensor zum Messen des magnetischen Flusses durch die Erregerwicklung oder einer mit dem magnetischen Fluss durch die Erregerwicklung korrelierenden Flussgröße unter Bildung eines Ist-Wertes, und einer Steuereinrichtung zur Ansteuerung der Erregerwicklung.

Bezüglich eines solchen Aktuators wird vorgeschlagen, dass die Steuereinrichtung derart ausgestaltet ist, dass sie die Erregerwicklung mit einem derartigen Strom beaufschlagt, dass der zeitliche Verlauf des Ist-Werts einer fest vorgegebenen Sollflusskurve entspricht.

Bezüglich der Vorteile des erfindungsgemäßen Aktuators nach Anspruch 7 sei auf die obigen Ausführungen im Zusammenhang mit dem erfindungsgemäßen Verfahren verwiesen.

Als besonders vorteilhaft wird es angesehen, wenn der beschriebene Aktuator bei einer Anordnung mit einem elektrischen Schalter eingesetzt wird und dazu dient, den elektrischen Schalter ein- oder auszuschalten. Die Erfindung bezieht sich somit außerdem auf eine Anordnung mit einem elektrischen Schalter.

Die Erfindung wird nachfolgend anhand von Ausführungsbeispielen näher erläutert; dabei zeigen beispielhaft

Figur 1 ein Ausführungsbeispiel für eine Anordnung mit einem Aktuator und einem mit dem Aktuator in Verbindung stehenden elektrischen Schalter, wobei der Aktuator eine Erregerwicklung, eine Steuereinrichtung und eine mit der Steuereinrichtung verbundene Hilfsspule zum Messen des magnetischen Flusses aufweist,

Figur 2 ein erstes Beispiel für eine vorgegebene Sollflusskurve, auf die die Steuereinrichtung gemäß Figur 1 den magnetischen Fluss regeln kann,

Figur 3 ein zweites Beispiel für eine vorgegebene Sollflusskurve, anhand derer die Steuereinrichtung gemäß Figur 1 den magnetischen Fluss regeln kann,

Figur 4 ein Ausführungsbeispiel für eine vorgegebene Sollflusskurve, mit der die Steuereinrichtung gemäß Figur 1 den magnetischen Fluss erfindungsgemäß regelt,

Figur 5 ein Ausführungsbeispiel für eine Anordnung mit einem Aktuator und einem elektrischen Schalter, wobei der Aktuator eine Erregerwicklung, eine Steuereinrichtung und einen mit der Steuereinrichtung verbundenen Hallsensor zum Messen des magnetischen Flusses aufweist, und

Figur 6 ein Ausführungsbeispiel für eine Anordnung mit einem Aktuator und einem elektrischen Schalter, wobei der Aktuator eine Erregerwicklung und eine Steuereinrichtung aufweist und zum Messen des magnetischen Flusses die Erregerwicklung nutzt.

In den Figuren werden der Übersicht halber für identische oder vergleichbare Komponenten stets dieselben Bezugszeichen verwendet.

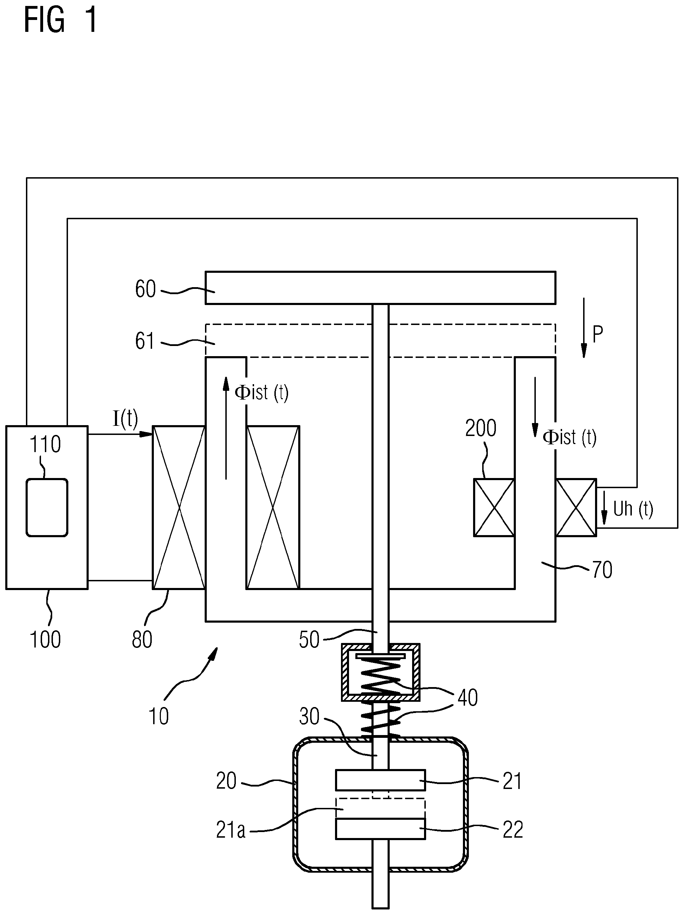

In der Figur 1 erkennt man einen Aktuator in Form eines elektromagnetischen Antriebs 10 für einen elektrischen Schalter 20; bei dem Schalter 20 kann es beispielsweise um einen elektrischen Leistungsschalter handeln. Der elektrische Schalter 20 umfasst einen beweglichen Schaltkontakt 21 sowie einen feststehenden Schaltkontakt 22.

Der bewegliche Schaltkontakt 21 steht mit einer Antriebsstange 30 des elektromagnetischen Antriebs 10 in Verbindung, die mit einer Federeinrichtung 40 zusammenwirkt. An die Federeinrichtung 40 ist außerdem eine weitere Antriebsstange 50 angekoppelt, die mit einem beweglichen Anker 60 des elektromagnetischen Antriebs 10 verbunden ist.

Der Anker 60 kann entlang einer vorgegebenen Schieberichtung P eine Hubbewegung ausführen und sich dabei in Richtung eines Jochs 70 des Antriebs 10 bewegen. Die Figur 1 zeigt den Anker 60 mit durchgezogenen Linien in einer geöffneten Position (nachfolgend auch Ausgangsposition genannt), in der er von dem Joch 70 getrennt ist. In der geöffneten Position des Ankers 60 befindet sich der bewegliche Schaltkontakt 21 in einer geöffneten Position, die in der Figur 1 ebenfalls mit durchgezogenen Linien dargestellt ist. Mit gestrichelten Linien sowie mit den Bezugzeichen 61 und 21a sind die geschlossene Position (nachfolgend auch Endstellung genannt) des Ankers 60, in der dieser auf dem magnetischen Joch 70 aufliegt und die geschlossene Position des beweglichen Schaltkontakts gezeigt.

Die Funktion der Federeinrichtung 40 besteht unter anderem darin, im geschlossenen Zustand des Schalters 20 eine vorgegebene Kontaktandruckkraft bereitzustellen; bei dem Ausführungsbeispiel gemäß Figur 1 wird die Federeinrichtung 40 die weitere Antriebsstange 50 in der Figur 1 nach oben zu drücken, so dass der Anker 60 stets mit einer Federkraft beaufschlagt wird, die ihn in die geöffnete Position bringen will und die im geschlossenen Zustand durch eine entsprechend große Haltekraft kompensiert werden muss.

Soll der elektrische Schalter 20 mit dem elektromagnetischen Antrieb 10 geschlossen werden, so wird in die Erregerwicklung 80 mittels einer Steuereinrichtung 100 ein Strom I(t) eingespeist, der einen magnetischen Fluss innerhalb der Erregerwicklung hervorruft und den Anker 60 entgegen der Federkraft der Federeinrichtung 40 in seine geschlossene Position bringt. Die Steuereinrichtung 100 umfasst vorzugsweise einen Mikroprozessor oder Mikrocontroller 110, der den Strom I(t) regelt, und zwar derart, dass der Verlauf des jeweiligen Werts (Ist-Werts) $\Phi ist(t)$ des magnetischen Flusses einer fest vorgegebenen Sollflusskurve Φsoll(t) entspricht.

Um diese Regelung des magnetischen Flusses zu ermöglichen, steht die Steuereinrichtung 100 mit einer Hilfsspule 200 in Verbindung, die das magnetische Joch 70 umgibt und von demselben magnetischen Fluss durchflossen wird wie die Erregerwicklung 80. Die Steuereinrichtung 100 bzw. deren Mikrocontroller 110 misst die an der Hilfsspule 200 abfallende elektrische Spannung Uh(t) unter Bildung eines Spulenspannungsmesswerts und ermittelt mit diesem unter Berücksichtigung des Induktionsgesetzes:

$$Uh(t) = N \cdot d\Phi ist(t)/dt$$

den magnetischen Fluss, der die Erregerwicklung 80 und die Hilfsspule 200 durchsetzt; in der Formel bezeichnet N die Wicklungsanzahl der Hilfsspule 200, Uh(t) die an der Hilfsspule 200 abfallende Spannung, Φist(t) den Ist-Wert des magnetischen Flusses und t die Zeit.

Unter Berücksichtigung des jeweiligen Istwerts Φist(t) des magnetischen Flusses steuert der Mikrocontroller 110 der Steuereinrichtung 100 den Strom I(t) durch die Erregerwicklung 80 derart, dass der Istwert Φist(t) des magnetischen Flusses im zeitlichen Verlauf einer fest vorgegebenen Sollflusskurve Φsoll(t) entspricht. Mit anderen Worten erfolgt die Regelung der Aktuatorbewegung bzw. die Regelung der Bewegung des Ankers 60 unabhängig von dessen tatsächlichen Bewegungsparametern, sondern ausschließlich anhand des magnetischen Flusses, der die Erregerwicklung 80 und die Hilfsspule 200 durchsetzt.

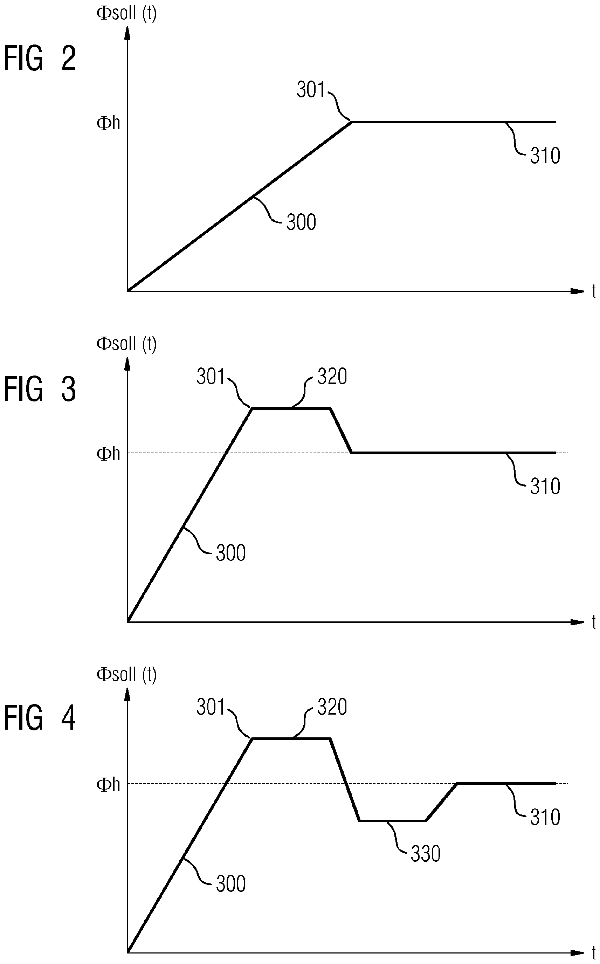

Die Figur 2 zeigt ein Beispiel für eine Sollflusskurve Φsoll(t), die der Mikrocontroller 110 zur Ansteuerung der Erregerwicklung 80 bzw. zur Bestimmung des Spulenstroms I(t) heranziehen kann. Man erkennt, dass die Sollflusskurve Φsoll(t) gemäß Figur 2 einen Anstiegsrampenabschnitt 300 aufweist, in dem die Sollflusswerte von 0 auf einen vorgegebenen Rampenendwert 301 vorzugsweise linear ansteigen.

An den Anstiegsrampenabschnitt 300 schließt sich ein Halteabschnitt 310 an, in dem die Sollflusskurve Φsoll(t) einen konstanten Haltewert Φh aufweist. Der Haltewert Φh ist derart bemessen, dass der magnetische Fluss durch die Erregerspule 80 ausreichend groß ist, um den beweglichen Anker 60 entgegen der Federkraft der Federeinrichtung 40 auf dem magnetischen Joch 70 zu halten und den elektrischen Schalter 20 bzw. dessen beweglichen Schaltkontakt 21 in der geschlossenen Schaltposition zu halten.

Bei dem Sollkurvenverlauf gemäß der Figur 2 stellt der Halteabschnitt 310 somit sicher, dass der bewegliche Anker 60 den Schalter 20 schließen sowie nachfolgend in der geschlossenen Stellung gehalten werden kann.

Die Figur 3 zeigt ein zweites Beispiel für eine Sollflusskurve Φsoll(t), die zur Ansteuerung der Erregerwicklung 80 gemäß Figur 1 vom Mikrocontroller 110 herangezogen werden kann.

Die Sollflusskurve Φsoll(t) weist einen Anstiegsrampenabschnitt 300 und einen Halteabschnitt 310 auf, die dem Anstiegsrampenabschnitt 300 und dem Halteabschnitt 310 gemäß Figur 2 entsprechen können. Im Unterschied zu dem Beispiel gemäß Figur 2 ist bei der Sollflusskurve Φsoll(t) gemäß Figur 3 zwischen dem Anstiegsrampenabschnitt 300 und dem Halteabschnitt 310 ein Beschleunigungsabschnitt 320 vorgesehen, bei dem die Sollflusswerte größer als im Halteabschnitt 310 bzw. größer als der Haltewert Φh bemessen sind. Der Beschleunigungsabschnitt 320 dient dazu, in der Anfangsphase der Beschleunigung des beweglichen Ankers 60 besonders große Beschleunigungskräfte hervorzurufen, um die Geschwindigkeit des Ankers 60 in der Anfangsphase besonders schnell zu erhöhen. Nachdem die Beschleunigungsphase abgeschlossen ist, werden die Sollflusswerte der Sollflusskurve wieder abgesenkt, nämlich auf den Haltewert Φh, der zum Halten des Ankers 60 in der geschlossenen Position geeignet ist. Mit anderen Worten werden die Sollflusswerte nach Abschluss des Beschleunigungsabschnitts 320 auf den Haltewert Φh abgesenkt, so dass sich der Halteabschnitt 310 ergibt, wie er im Zusammenhang mit der Figur 2 bereits erläutert worden ist.

Die Figur 4 zeigt ein erfindungsgemäßes Ausführungsbeispiel für eine Sollflusskurve Φsoll(t), bei der zusätzlich zu dem Anstiegsrampenabschnitt 300, dem Beschleunigungsabschnitt 320 und dem Halteabschnitt 310 ein Bremsabschnitt 330 vorgesehen ist. Der Bremsabschnitt 330 liegt zeitlich zwischen dem Beschleunigungsabschnitt 320 und dem Halteabschnitt 310 und dient dazu, die Geschwindigkeit des Ankers 60 vor dem Auftreffen auf dem magnetischen Joch 70 auf einen Wert abfallen zu lassen, der einen möglichst geringen Verschleiß der Aktuatorteile des Aktuators 10 sicherstellt. Im Bremsabschnitt 330 sind die Sollflusswerte der Sollflusskurve Φsoll(t) vorzugsweise kleiner als der Haltewert Φh, mit dem sich der Anker 60 in seiner Endlage auf dem Joch 70 halten lässt. Aus diesem Grunde schließt sich an den Bremsabschnitt 330 der Halteabschnitt 310 an, indem der Haltewert Φh eingestellt wird, mit dem eine dauerhafte Positionierung des Ankers 60 auf dem Joch 70 bzw. ein sicheres Halten der geschlossenen Stellung des elektrischen Schalters 20 gewährleistet werden.

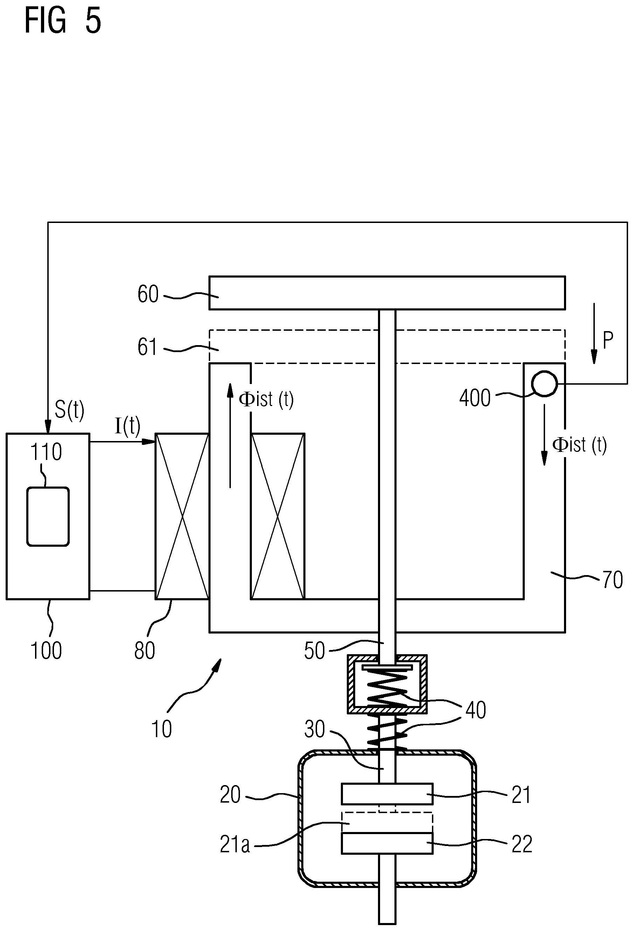

Die Figur 5 zeigt ein zweites Ausführungsbeispiel für einen Aktuator 10 und einen elektrischen Schalter 20, bei der eine Steuereinrichtung 100 des Aktuators 10 eine Regelung des Ist-wertes Φist(t) des magnetischen Flusses durch das Joch 70 und dem zugeordneten beweglichen Anker 60 hervorruft. Die Anordnung gemäß Figur 5 entspricht von dem Aufbau her im Wesentlichen dem Ausführungsbeispiel gemäß Figur 1 mit dem Unterschied, dass zum Messen des Istwerts Φist(t) des magnetischen Flusses keine Hilfsspule vorgesehen ist, sondern ein Hall-Sensor 400, der mit der Steuereinrichtung 100 und dem Mikrocontroller 110 verbunden ist. Der Hall-Sensor 400 erzeugt ein Messsignal S(t), das vom Hall-Sensor 400 zur Steuereinrichtung 100 und zum Mikrocontroller 110 übermittelt wird. Anhand des Messsignals S(t) kann der Mikrocontroller 110 den magnetischen Fluss im magnetischen Joch 70 bzw. den magnetischen Fluss durch die Erregerwicklung 80 ermitteln und den Strom I(t) durch die Erregerwicklung 80 derart einstellen, dass der magnetische Fluss in der Erregerwicklung 80 bzw. im magnetischen Joch 70 im zeitlichen Verlauf einer vorgegebenen Sollflusskurve Φsoll(t) entspricht, wie sie beispielhaft im Zusammenhang mit den Figuren 2 und 3 oben sowie erfindungsgemäß im Zusammenhang mit der Figur 4 gezeigt worden ist.

Zusammengefasst unterscheidet sich das Ausführungsbeispiel gemäß Figur 5 von dem Ausführungsbeispiel gemäß Figur 1 somit lediglich in der Erfassung des Istwerts Φist(t) des magnetischen Flusses, der durch die Erregerwicklung 80, das magnetische Joch 70 und den Anker 60 fließt.

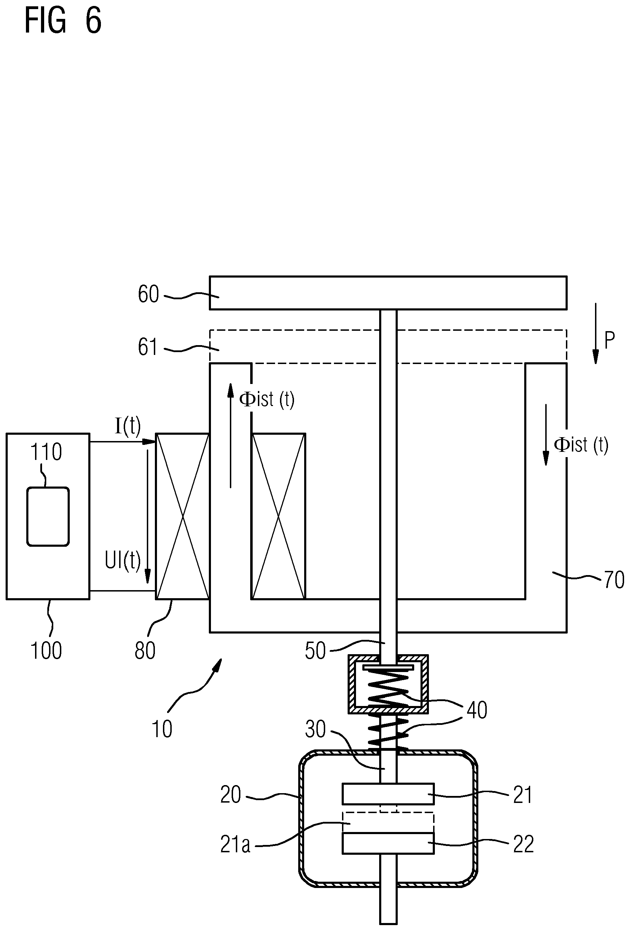

Die Figur 6 zeigt ein weiteres Ausführungsbeispiel für eine Anordnung mit einem Aktuator 10 und einem elektrischen Schalter 20. Die Anordnung gemäß Figur 6 entspricht im Wesentlichen der Anordnung gemäß den Figuren 1 und 5 mit dem Unterschied, dass die Steuereinrichtung 100 bzw. deren Mikrocontroller 110 keinen separaten Sensor zum Messen des magnetischen Flusses in der Erregerwicklung 80 bzw. im Joch 70, also weder eine Hilfsspule 200 noch einen Hall-Sensor 400, aufweist. Zum Messen des Istwerts Φist(t) des magnetischen Flusses in der Erregerwicklung 80 misst die Steuereinrichtung 100 bzw. deren Mikrocontroller 110 die Spannung Ul(t), die während des Stromflusses I(t) durch die Erregerwicklung 80 an der Erregerwicklung abfällt. Mit Hilfe des entsprechenden Spulenspannungsmesswerts kann der Mikrocontroller 110 nachfolgend durch Integration den Istwert Φist(t) des magnetischen Flusses ermitteln, beispielsweise unter Heranziehung des Induktionsgesetzes, das bereits oben erläutert worden ist.

Unter Berücksichtigung der Istwerte Φist(t) des magnetischen Flusses wird der Mikrocontroller 110 nachfolgend den Strom I(t) derart regeln, dass der Istwert Φist(t) des magnetischen Flusses einer vorgegebenen Sollflusskurve entspricht, wie sie beispielhaft in den Figuren 2 und 3 und erfindungsgemäß in Figur 4 gezeigt ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

Bezugszeichenliste

| 10 | elektromagnetischer Antrieb / Aktuator |
| 20 | Schalter |
| 21 | beweglicher Schaltkontakt |
| 21a | Schaltkontakt in geschlossener Position / Endstellung |
| 22 | feststehender Schaltkontakt |
| 30 | Antriebsstange |
| 40 | Federeinrichtung |
| 50 | weitere Antriebsstange |
| 60 | Anker |
| 61 | Anker in geschlossener Stellung / Endstellung |
| 70 | Joch |
| 80 | Erregerwicklung |
| 100 | Steuereinrichtung |
| 110 | Mikrocontroller |
| 200 | Hilfsspule |
| 300 | Anstiegsrampenabschnitt |
| 301 | Rampenendwert |
| 310 | Halteabschnitt |
| 320 | Beschleunigungsabschnitt |
| 330 | Bremsabschnitt |
| 400 | Hall-Sensor |
| I(t) | Spulenstrom |
| $\Phi$ist(t) | magnetischer Fluss |
| $\Phi$h | Haltewert |
| $\Phi$soll(t) | Sollflusskurve |
| $\Phi$ist(t) | Istwert |
| P | Schieberichtung |
| S(t) | Messsignal |
| Uh(t) | Spannung |
| Ul(t) | Spannung |

## Patentansprüche

1. Verfahren zum Ansteuern eines elektromagnetischen Aktuators (10), der eine Erregerwicklung (80) zum Erzeugen eines Magnetfeldes und einen beweglichen Anker (60) umfasst, wobei bei dem Verfahren

   - zum Bewegen des Ankers (60) von einer vorgegebenen Ausgangsstellung in eine vorgegebenen Endstellung ein magnetischer Fluss in der Erregerwicklung (80) erzeugt wird und
   - der magnetische Fluss durch die Erregerwicklung (80) oder eine mit dem magnetischen Fluss durch die Erregerwicklung (80) korrelierende Flussgröße unter Bildung eines Ist-Wertes ($\Phi$ist(t)) gemessen wird, wobei
   zum Bewegen des Ankers (60) von der Ausgangsstellung in die Endstellung der magnetische Fluss durch die Erregerwicklung (80) geregelt wird, und zwar derart, dass der Verlauf des Ist-Werts ($\Phi$ist(t)) einer fest vorgegebenen Sollflusskurve (($\Phi$soll(t)) entspricht
   **dadurch gekennzeichnet, dass** die Sollflusskurve (Φsoll(t)) einen Anstiegsrampenabschnitt (300), einen Halteabschnitt (310) und mindestens einen dazwischen liegenden Zwischenabschnitt aufweist, wobei die Sollflusskurve (Φsoll(t)) als Zwischenabschnitt einen Beschleunigungsabschnitt (320), in dem die Sollflusswerte größer als im Halteabschnitt (310) sind, und einen Bremsabschnitt (330) aufweist, in dem die Sollflusswerte kleiner als im Halteabschnitt (310) sind, aufweist.

2. Verfahren nach Anspruch 1,
   **dadurch gekennzeichnet, dass**
   die Spannung an der Erregerwicklung (80) und/oder der Strom (I(t)) durch die Erregerwicklung (80) im Rahmen des Regelverfahrens derart geregelt wird, dass der Istwert (Φist(t)) der vorgegebenen Sollflusskurve (Φsoll(t)) entspricht.

3. Verfahren nach einem der voranstehenden Ansprüche,
   **dadurch gekennzeichnet, dass**
   die Sollflusskurve (Φsoll(t)) des Anstiegsrampenabschnitts (300) von Null auf einen vorgegebenen Rampenendwert (301) ansteigt.

4. Verfahren nach einem der voranstehenden Ansprüche,
   **dadurch gekennzeichnet, dass**

   - die Sollflusskurve (Φsoll(t)) des Halteabschnitts (310) einen konstanten Haltewert (Φh) aufweist,
   - wobei der Haltewert (Φh) derart bemessen ist, dass der magnetische Fluss durch die Erregerwicklung (80) den Anker (60) in der Endlage halten kann.

5. Verfahren nach einem der voranstehenden Ansprüche,
   **dadurch gekennzeichnet, dass**
   der magnetische Fluss durch die Erregerwicklung (80) oder die mit dem magnetischen Fluss durch die Erregerwicklung (80) korrelierende Flussgröße mittels eines Hall-Sensors (400) gemessen wird.

6. Verfahren nach einem der voranstehenden Ansprüche,
   **dadurch gekennzeichnet, dass**
   der magnetische Fluss durch die Erregerwicklung (80) oder die mit dem magnetischen Fluss durch die Erregerwicklung (80) korrelierende Flussgröße gemessen wird, indem

   - die Spannung an der Erregerwicklung (80) oder die Spannung an einer Hilfsspule (200), die von dem Fluss, der auch die Erregerwicklung (80) durchsetzt, oder einem dazu proportionalen Fluss durchsetzt wird, unter Bildung eines Spulenspannungsmesswertes gemessen wird und
   - der Ist-Wert (Φist(t)) zumindest auch durch Integration des Spulenspannungsmesswertes ermittelt wird.

7. Aktuator (10) mit einer Erregerwicklung (80) zum Erzeugen eines Magnetfeldes, einem beweglichen Anker (60), einem Sensor zum Messen des magnetischen Flusses durch die Erregerwicklung (80) oder einer mit dem magnetischen Fluss durch die Erregerwicklung (80) korrelierenden Flussgröße unter Bildung eines Ist-Wertes (Φist(t)), und einer Steuereinrichtung (100) zur Ansteuerung der Erregerwicklung (80), wobei die Steuereinrichtung (100) derart ausgestaltet ist, dass sie die Erregerwicklung (80) mit einem derartigen Strom beaufschlagt, dass der zeitliche Verlauf des Ist-Werts ((Φist(t)) einer fest vorgegebenen Sollflusskurve (Φsoll(t)) entspricht,
   **dadurch gekennzeichnet, dass**
   die Sollflusskurve (Φsoll(t)) einen Anstiegsrampenabschnitt (300), einen Halteabschnitt (310) und mindestens einen dazwischen liegenden Zwischenabschnitt aufweist, wobei die Sollflusskurve (Φsoll(t)) als Zwischenabschnitt einen Beschleunigungsabschnitt (320), in dem die Sollflusswerte größer als im Halteabschnitt (310) sind, und einen Bremsabschnitt (330), in dem die Sollflusswerte kleiner als im Halteabschnitt (310) sind, aufweist.

8. Anordnung mit einem Aktuator (10) nach Anspruch 7 und einem elektrischen Schalter (20), wobei der Aktuator (10) zum Bewegen eines beweglichen Kontakts des Schalters (20) beim Ein- und/oder Ausschalten dient.

**Claims**

1. Method for driving an electromagnetic actuator (10) which comprises an exciter winding (80) for generating a magnetic field and a movable armature (60), wherein in the method

   - in order to move the armature (60) from a predefined starting position into a predefined end position, a magnetic flux is generated in the exciter winding (80), and
   - the magnetic flux through the exciter winding (80), or a flux variable which correlates with the magnetic flux through the exciter winding (80), is measured by forming an actual value (Φist(t)), wherein
   in order to move the armature (60) from the starting position into the end position, the magnetic flux is regulated by the exciter winding (80), and to be precise in such a way that the profile of the actual value (Φist(t)) corresponds to a permanently predefined setpoint flux curve (Φsoll(t)), **characterized in that** the setpoint flux curve (Φsoll(t)) has a rise ramp section (300), a holding section (310) and at least one intermediate section located between them, wherein the setpoint flux curve (Φsoll(t)) has, as an intermediate section, an acceleration section (320) in which the setpoint flux values are greater than in the holding section (310), and a braking section (330) in which the setpoint flux values are lower than in the holding section (310).

2. Method according to Claim 1, **characterized in that** the voltage at the exciter winding (80) and/or the current (I(t)) through the exciter winding (80) is regulated within the scope of the regulation method in such a way that the actual value (Φist(t)) corresponds to the predefined setpoint flux curve (Φsoll(t)).

3. Method according to one of the preceding claims, **characterized in that** the setpoint flux curve (Φsoll (t)) of the rise ramp section (300) rises from zero to a predefined ramp end value (301).

4. Method according to one of the preceding claims, **characterized in that**

   - the setpoint flux curve (Φsoll(t)) of the holding section (310) has a constant holding value (Φh),
   - wherein the holding value (Φh) is dimensioned in such a way that the magnetic flux through the exciter winding (80) can hold the armature (60) in the end position.

5. Method according to one of the preceding claims, **characterized in that** the magnetic flux through the exciter winding (80), or the flux variable which correlates with the magnetic flux through the exciter winding (80), is measured by means of a Hall sensor (400) .

6. Method according to one of the preceding claims, **characterized in that** the magnetic flux through the exciter winding (80), or the flux variable which correlates with the magnetic flux through the exciter winding (80), is measured by

   - measuring the voltage at the exciter winding (80) or the voltage at an auxiliary coil (200) which is penetrated by the flux which also penetrates the exciter winding (80), or by a flux which is proportional thereto, by forming a coil voltage measured value, and
   - determining the actual value (Φist(t)) at least also by integration of the coil voltage measured value.

7. Actuator (10) having an exciter winding (80) for generating a magnetic field, a movable armature (60), a sensor for measuring the magnetic flux through the exciter winding (80), or a flux variable which correlates with the magnetic flux through the exciter winding (80), by forming an actual value (Φist(t)), and a control device (100) for driving the exciter winding (80), wherein the control device (100) is configured in such a way that it applies such a current to the exciter winding (80) that the time profile of the actual value (Φist(t)) corresponds to a permanently predefined setpoint flux curve (Φsoll(t)), **characterized in that** the setpoint flux curve (Φsoll(t)) has a rise ramp section (300), a holding section (310) and at least one intermediate section located between them, wherein the setpoint flux curve (Φsoll(t)) has, as an intermediate section, an acceleration section (320) in which the setpoint flux values are greater than in the holding section (310), and a braking section (330) in which the setpoint flux values are lower than in the holding section (310).

8. Arrangement having an actuator (10) according to Claim 7 and an electrical switch (20), wherein the actuator (10) serves to move a movable contact of the switch (20) during the switching on and/or off.

**Revendications**

1. Procédé de commande d'un actionneur (10) électromagnétique, qui comprend une bobine (80) d'excitation pour produire un champ magnétique et une armature (60) mobile, procédé dans lequel

   - pour faire passer l'armature (60) d'une position initiale donnée à l'avance à une position finale donnée à l'avance, on produit un flux magnétique dans la bobine (80) d'excitation et
   - on mesure le flux magnétique dans la bobine (80) d'excitation ou une grandeur de flux se corrélant au flux magnétique dans la bobine (80) d'excitation en formant une valeur (Φist(t)) réelle, dans lequel, pour faire passer l'armature (80) de la position initiale à la position finale, on règle le flux magnétique dans la bobine (80) d'excitation et cela de manière à ce que la courbe de la valeur (Φist(t)) réelle corresponde à une courbe (Φsoll(t)) de flux de consigne fixe donnée à l'avance, **caractérisé en ce que** la courbe (Φsoll(t)) de flux de consigne a un tronçon (300) de rampe montante, un tronçon (310) de maintien et au moins un tronçon intermédiaire se trouvant entre eux, la courbe ($\Phi$soll(t)) de flux de consigne ayant, comme tronçon intermédiaire, un tronçon (320) d'accélération, dans lequel les valeurs de flux de consigne sont plus grandes que dans le tronçon (310) de maintien, et un tronçon (330) de freinage, dans lequel les valeurs de flux de consigne sont plus petites que dans le tronçon (310) de maintien.

2. Procédé suivant la revendication 1,
**caractérisé en ce que**
l'on règle, dans le cadre du procédé de réglage, la tension à la bobine (80) d'excitation et/ou le courant (I(t)) dans la bobine (80) d'excitation, de manière à ce que la valeur ($\Phi$ist(t)) réelle corresponde à la courbe ($\Phi$soll(t)) de flux de consigne donnée à l'avance.

3. Procédé suivant l'une des revendications précédentes,
**caractérisé en ce que**
la courbe ($\Phi$soll(t)) de flux de consigne du tronçon (300) de rampe montante s'élève de zéro à une valeur (301) finale de rampe donnée à l'avance.

4. Procédé suivant l'une des revendications précédentes,
**caractérisé en ce que**

- la courbe ($\Phi$soll(t)) de flux de consigne du tronçon (310) de maintien a une valeur ($\Phi$h) de maintien constante,
- dans laquelle la valeur ($\Phi$h) de maintien est telle que le flux magnétique, dans la bobine (80) d'excitation peut maintenir l'armature (60) dans la position finale.

5. Procédé suivant l'une des revendications précédentes,
**caractérisé en ce que**
l'on mesure, au moyen d'un capteur (400) de Hall, le flux magnétique dans la bobine (80) d'excitation ou la grandeur de flux se corrélant au flux magnétique dans la bobine (80) d'excitation.

6. Procédé suivant l'une des revendications précédentes,
**caractérisé en ce que**
l'on mesure le flux magnétique dans la bobine (80) d'excitation ou la grandeur de flux se corrélant au flux magnétique dans la bobine (80) d'excitation, en

- mesurant, avec formation d'une valeur de mesure de tension de bobine, la tension à la bobine (80) d'excitation ou la tension à une bobine (200) auxiliaire, traversée par le flux, qui traverse aussi la bobine (80) d'excitation, ou par un flux, qui y est proportionnel et
- déterminant la valeur ($\Phi$ist(t)) réelle, au moins aussi, par intégration de la valeur de mesure de la tension de bobine.

7. Actionneur (10), comprenant une bobine (80) d'excitation pour la production d'un champ magnétique, une armature (60) mobile, un capteur de mesure du flux magnétique dans la bobine (80) d'excitation ou d'un flux magnétique se corrélant au flux magnétique dans la bobine (80) d'excitation, en formant une valeur ($\Phi$ist(t)) réelle, et un dispositif (100) de commande pour commander la bobine (80) d'excitation, le dispositif (100) de commande étant conformé de manière à alimenter la bobine (80) d'excitation en un courant tel que la courbe en fonction du temps de la valeur ($\Phi$ist(t)) réelle corresponde à une courbe ($\Phi$soll(t)) de flux de consigne fixe donnée à l'avance,
**caractérisé en ce que**
la courbe ($\Phi$soll(t)) de flux de consigne a un tronçon (300) de rampe montante, un tronçon (310) de maintien et au moins un tronçon intermédiaire se trouvant entre eux, la courbe ($\Phi$soll(t)) de flux de consigne ayant, comme tronçon intermédiaire, un tronçon (320) d'accélération, dans lequel les valeurs de flux de consigne sont plus grandes que dans le tronçon (310) de maintien, et un tronçon (330) de freinage, dans lequel les valeurs de flux de consigne sont plus petites que dans le tronçon (310) de maintien.

8. Agencement ayant un actionneur (10) suivant la revendication 7 et un interrupteur (20) électrique, l'actionneur (10) servant à déplacer un contact mobile de l'interrupteur (20) lors de la mise en circuit et/ou de la mise hors circuit.

# FIG 1

60

61

$\Phi_{ist}(t)$

P

I(t)

110

200

$\Phi_{ist}(t)$

100

80

Uh (t)

70

10

50

40

30

20

21

21a

22

FIG 2

FIG 3

FIG 4

# FIG 5

## FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19544207 A1
- WO 9721237 A2
- DE 19535211 A1
- DE 102008040668 A1
- DE 2011075935 A1
- EP 0376493 A
- GB 2310540 A
- WO 9007188 A